# EUROPÄISCHE PATENTSCHRIFT

(11) **EP 0 494 427 B1**
(45) Veröffentlichungstag und Bekanntmachung des Hinweises auf die Patenterteilung: **24.05.1995**
(21) Anmeldenummer: 91121909.5
(22) Anmeldetag: 20.12.1991
(51) Int. Cl.: G01R 15/00, G01R 1/02

(54) **Elektrizitätszähler**
Electricity meter
Compteur d'électricité

(30) Priorität: 09.01.1991 CH 37/91
(43) Veröffentlichungstag der Anmeldung: 15.07.1992
(73) Patentinhaber: ZELLWEGER LUWA AG, CH-8610 Uster (CH)
(72) Erfinder: Manser, Beat, CH-8645 Jona (CH); Nussbaumer, Roland, CH-8610 Uster (CH)

(56) Entgegenhaltungen:
- EP-A- 0 092 303
- US-A- 4 602 211
- US-A- 4 959 607

## Beschreibung

Die vorliegende Erfindung betrifft einen Elektrizitätszähler mit einer Messzelle mit einem Spannungskreis, einem Strompfad und mit einer Anordnung zur wahlweisen Verbindung des Spannungskreises mit dem Strompfad oder mit einem Eichsystem.

Anordnungen dieser Art sind bei jedem Elektrizitätszähler erforderlich, weil ja bekanntlich jeder Zähler geeicht werden muss. Eine bekannte Anordnung dieser Art ist durch eine gabelförmige Kurzschlussbrücke gebildet, welche durch zwei Schraubenklemmen gehalten wird, von denen die eine an den Strompfad und die andere an den Spannungskreis des Zählers angeschlossen ist. Für den Eichvorgang, bei dem eine Eichspannungsquelle des Eichsystems an den Spannungskreis angeschlossen wird, muss die Kurzschlussbrücke unterbrochen und verschoben werden. Jeder Eichvorgang erfordert also mehrere Manipulationen und bedingt somit einen nicht unerheblichen und unerwünschten Aufwand.

Durch die Erfindung soll nun ein Elektrizitätszähler angegeben werden, der so ausgebildet ist, dass das Umschalten der Anordnung zwischen dem Strompfad und dem Eichsystem mit einem Minimum an Aufwand erfolgen kann.

Diese Aufgabe wird erfindungsgemäss dadurch gelöst, dass die Anordnung eine im Gehäuse des Zählers vorhandene Oeffnung zur Aufnahme eines mit dem Eichsystem verbundenen Kontaktorgans und einen Schwenkhebel umfasst, welcher beim Einführen des Kontaktorgans in die genannte Oeffnung von einer den Spannungskreis mit dem Strompfad verbindenden Betriebsstellung in eine den Spannungskreis mit dem Eichsystem verbindende Eichstellung verstellt wird und welcher beim Herausziehen des Kontaktorgans von der Eichstellung in die Betriebsstellung verstellt wird.

Bei der erfindungsgemässen Anordnung braucht beim Eichvorgang lediglich das Kontaktorgan in die Oeffnung gesteckt zu werden; das ist die einzige erforderliche Manipulation. Somit ergibt sich eine ganz erhebliche Reduktion des für die Eichung erforderlichen Aufwands. Da die für das Umschalten zwischen Eich- und Betriebsstellung vorzunehmende Operation praktisch nur aus einem einzigen Handgriff besteht, liegt sogar eine vollständige Automatisierung des Eichvorgangs im Bereich des Möglichen, indem beispielsweise ein Kontaktierungsadapter mit einem bolzenartigen Kontaktorgan verwendet wird.

Nachstehend wird die Erfindung anhand eines Ausführungsbeispiels und der Zeichnungen näher erläutert; es zeigt:
- Fig. 1: eine Vorderansicht einer Messzelle eines Elektrizitätszählers,
- Fig. 2: eine Ansicht in Richtung des Pfeiles II von Fig. 1,
- Fig. 3: eine Draufsicht auf die Messzelle von Fig. 1,
- Fig. 4: eine Vorderansicht der Messzelle bei abgenommenem Gehäusedeckel; und
- Fig. 5: eine schematische Perspektivdarstellung einer Messzelle zur Funktionserläuterung.

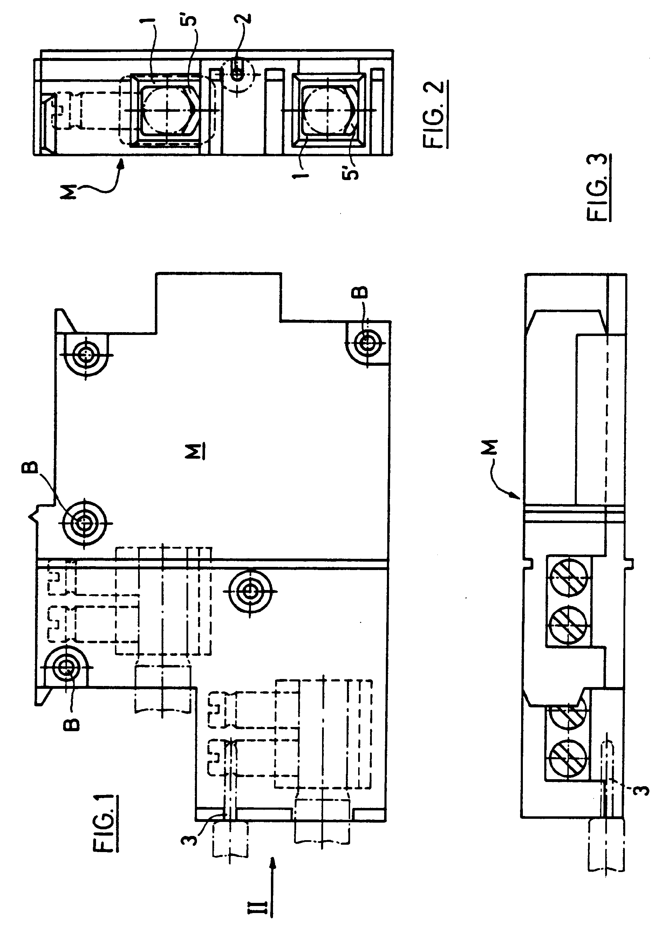

Die Figuren 1 bis 3 zeigen eine Messzelle M eines Elektrizitätszählers in drei Ansichten im Massstab von 1,5 : 1. Diese Messzelle hat darstellungsgemäss die Form einer flachen Schachtel mit den ungefähren Abmessungen 90x60x16 Millimeter und sie enthält einen Messkreis für eine Phase des zu messenden Stroms. Ist dieser Strom ein dreiphasiger Wechselstrom, dann enthält der betreffende Elektrizitätszähler drei derartige Messzellen M und ein Nulleitermodul von gleicher Form, wodurch ein durchgehend modularer Aufbau und ein einheitliches Aussehen der Elektrizitätszähler erreicht wird. An der Aussenwand der Messzelle M vorgesehene Rippen und Nuten dienen zur Zentrierung der einzelnen Module im Zählergehäuse und untereinander; mit dem Bezugszeichen B sind Nieten zur Befestigung des Gehäusedeckels bezeichnet.

Jede Messzelle M enthält insbesondere zwei Anschlussklemmen 1 eines Strompfades, welche darstellungsgemäss nicht, wie bisher üblich, neben-, sondern übereinander angeordnet sind, wodurch sich für einen Dreiphasenzähler eine beachtliche Reduktion der Gehäusebreite ergibt. Selbstverständlich müssen die beiden Anschlussklemmen 1 nicht unbedingt miteinander fluchten; sie können gegeneinander auch leicht versetzt sein. Wesentlich ist, dass sie über- und nicht nebeneinander liegen. Der gegenseitige Abstand kann dabei minimal sein, da ja die beiden Anschlussklemmen des Strompfades einer Phase die gleiche Spannung aufweisen und somit nicht die für die Erzielung der zwischen zwei Phasen vorgeschriebenen Stossspannungsfestigkeit erforderliche Mindestdistanz nötig ist. Der Querschnitt der Anschlussklemmen kann bei der Anordnung übereinander wesentlich grösser gewählt werden als bisher und er kann damit in weiten Grenzen der jeweiligen Stromstärke angepasst werden.

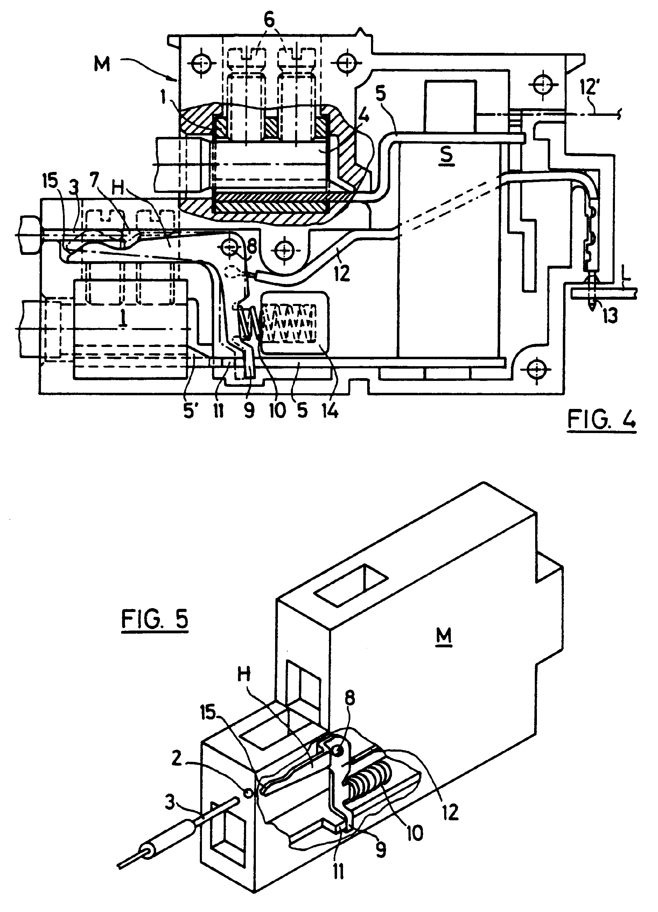

Wie insbesondere aus Fig. 2 ersichtlich ist, weist die Messzelle M neben den Anschlussklemmen 1 noch eine Anschlussbuchse 2 für einen bananensteckerartigen Stift oder Bolzen 3 auf, dessen Funktion bei der nun folgenden Beschreibung der Fig. 4 und 5 erläutert wird.

Fig. 4 zeigt eine Vorderansicht der Messzelle M bei abgenommenem Gehäusedeckel im Massstab von 2:1, welche im Bereich der oberen Anschlussklemme 1 von Fig. 1 teilweise geschnitten ist. Fig. 5 zeigt eine schematische, teilweise aufgeschnittene, Perspektivdarstellung der Messzelle M. Fig. 4 zeigt die Messzelle M mit in den Anschlussklemmen 1 festgeklemmten Anschlusslitzen 4 und mit in die Buchse 2 eingestecktem Stift 3; in Fig. 5 ist der Stift 3 nicht in die Buchse 2 eingesteckt. Gemäss Fig. 4 ist an die Anschlussklemmen 1 ein Stromsensor S angeschlossen, welcher aber nicht Gegenstand der vorliegenden Patentanmeldung bildet und daher hier auch nicht näher beschrieben wird. Der Stromsensor S enthält unter anderem einen durch einen Flachleiter gebildeten Strombügel, welcher zwei zu den Anschlussklemmen 1 führende Stromschienen 5 aufweist. Die letzteren sind im Bereich der Anschlussklemmen 1 in Form einer Rinne 5′ (siehe auch Fig. 2) ausgebildet, in welche die jeweilige Anschlusslitze 4 hineingelegt und durch Schrauben 6 festgeklemmt ist. Die Anschlussklemmen 1 sind in entsprechenden Aussparungen des Gehäuses der Messzelle M fixiert.

Der schon erwähnte Stift oder Bolzen 3 ist mit der Spannungsquelle eines Eichsystems (nicht dargestellt) verbunden und dient zu der für jede Messzelle M zwingend vorgeschriebenen Eichung des Elektrizitätszählers. Bei dieser Eichung wird der Stift 3 in die Buchse 2 geschoben und dadurch eine Verbindung zwischen dem genannten Eichsystem und dem Spannungskreis des Elektrizitätszählers hergestellt, welcher Spannungskreis im Betriebszustand des Zählers mit dessen Strompfad, also mit einer der Stromschienen 5, verbunden ist. Der Spannungskreis ist in Fig. 4 durch eine Leiterplatte L symbolisiert.

Fig. 4 zeigt die Messzelle während der Eichung, also bei in die Buchse 2 eingestecktem Stift 3. Darstellungsgemäss geht die Buchse 2 im Gehäuseinnern in eine Ausformung 7 über, in welcher ein abgewinkelter, an einer Drehachse 8 gelagerter Schwenkhebel H angeordnet ist. Das in Fig. 4 untere Ende des Schwenkhebels H ist als Kontaktteil 9 ausgebildet, welcher im Betriebszustand des Zählers, also bei nicht eingestecktem Stift 3, durch eine Feder 10 gegen einen von der an der unteren Anschlussklemme 1 liegenden Stromschiene 5 seitlich abstehenden Nocken 11 gedrückt wird. Dadurch ist im Betriebszustand des Zählers, in der strichpunktiert eingezeichneten Stellung des Schwenkhebels H, von der unteren Stromschiene 5 über den Nocken 11, den Schwenkhebel H, eine am Schwenkhebel H befestigte und mit diesem leitend verbundene, flexible Litze 12 und einen Stecker 13 eine Verbindung mit dem Spannungskreis der Messzelle M (Leiterplatte L) hergestellt.

Bezogen auf Fig. 4 ist oberhalb der Leiterplatte L eine zweite Leiterplatte angeordnet, welche die Elektronik zur Auswertung der Signale des Stromsensors S enthält. Diese Signale sind über eine durch eine strichpunktierte Linie 12′ symbolisierte Litze nach aussen geführt.

Die den Kontaktteil 9 des Schwenkhebels H gegen den Nocken 11 drückende Druckfeder 10 ist in einer Fassung 14 des Messzellengehäuses gehalten und elektrisch isoliert. Die Druckfeder 10 ist am Schwenkhebel H an einem mit Rillen oder mit einem anderen Befestigungsmittel versehenen Vorsprung fixiert.

Im Bereich des in der Bahn des Stiftes 3 bei dessen Einschieben in die Buchse 2 liegendes Endes seines horizontalen Arms weist der Schwenkhebel H eine schräg zur Längsachse des Stiftes 3 verlaufende und diese kreuzende Betätigungsfläche 15 auf, gegen welche der Stift 3 beim Einschieben in die Buchse 2 drückt. Dadurch wird der Schwenkhebel H aus seiner in Fig. 4 strichpunktiert eingezeichneten Betriebsstellung in die mit vollen Linien eingezeichnete Eichstellung geschwenkt, in welcher der Kontakt zwischen dem Nocken 11 und dem Schwenkhebelende 9 und damit zwischen der Stromschiene 5 und dem Spannungskreis L der Messzelle unterbrochen ist. Dafür besteht nun über den Schwenkhebel H eine elektrische Verbindung zwischen dem Stift 3 und damit dem Eichsystem, und dem Spannungskreis der Messzelle des Elektrizitätszählers.

Die beschriebene Anordnung zur wahlweisen Verbindung des Spannungskreises mit dem Strompfad oder mit dem Eichsystem, welche aus der Buchse 2 und aus dem Schwenkhebel H besteht, vereinfacht den Aufwand für das Umschalten von Betriebs- auf Eichzustand und umgekehrt ganz wesentlich, indem sie die dafür erforderlichen Tätigkeiten auf das Hineinstecken eines Steckers in eine Buchse und auf dessen Herausziehen aus dieser reduziert.

## Patentansprüche

1. Elektrizitätszähler mit einer Messzelle (M) mit einem Spannungskreis (L), einem Strompfad (5) und mit einer Anordnung zur wahlweisen Verbindung des Spannungskreises (L) mit dem Strompfad (5) oder mit einem Eichsystem, dadurch gekennzeichnet, dass die Anordnung eine im Gehäuse des Zählers vorhandene Oeffnung (2) zur Aufnahme eines mit dem Eichsystem verbundenen Kontaktorgans (3) und einen Schwenkhebel (H) umfasst, welcher beim Einführen des Kontaktorgans (3) in die genannte Oeffnung (2) von einer den Spannungskreis (L) mit dem Strompfad (5) verbindenden Betriebsstellung in eine den Spannungskreis (L) mit dem Eichsystem verbindende Eichstellung verstellt wird und welcher beim Herausziehen des Kontaktorgans (3) von der Eichstellung in die Betriebsstellung verstellt wird.

2. Elektrizitätszähler nach Anspruch 1, dadurch gekennzeichnet, dass zwischen dem Schwenkhebel (H) und dem Spannungskreis (L) eine feste, vorzugsweise durch eine flexible Litze (12) gebildete, elektrische Verbindung besteht.

3. Elektrizitätszähler nach Anspruch 2, dadurch gekennzeichnet, dass der Schwenkhebel (H) zweiarmig ausgebildet, und dass der eine Hebelarm (9) für die Herstellung der Verbindung zwischen Spannungskreis (L) und Strompfad (5) und der andere für die Herstellung derjenigen zwischen Spannungskreis (L) und Eichsystem vorgesehen ist.

4. Elektrizitätszähler nach Anspruch 3, dadurch gekennzeichnet, dass der Strompfad eine Stromschiene (5) mit einem von dieser abstehenden Kontaktnocken (11) aufweist, und dass der eine Arm (9) des Schwenkhebels (H) als in der Betriebsstellung mit diesem Kontaktnocken elektrisch verbundener Kontaktteil ausgebildet ist.

5. Elektrizitätszähler nach Anspruch 4, gekennzeichnet durch eine den den Kontaktteil bildenden einen Hebelarm (9) gegen den Kontaktnocken (11) drückende Feder (10).

6. Elektrizitätszähler nach Anspruch 1, dadurch gekennzeichnet, dass das Kontaktorgan durch einen steckerartigen Stift oder Bolzen (3) gebildet und die Oeffnung (2) buchsenartig ausgebildet ist, und dass der Schwenkhebel (H) federnd in die Bahn des Bolzens bei dessen Einführen in die Buchse ragt.

7. Elektrizitätszähler nach den Ansprüchen 3 und 6, dadurch gekennzeichnet, dass der andere Arm des Schwenkhebels (H) eine schräg zur Längsachse der Buchse (2) und damit des Bolzens (3) verlaufende und diese in der Betriebsstellung des Schwenkhebels (H) kreuzende Betätigungsfläche (15) aufweist.

## Claims

1. Electricity meter having a measurement cell (M) having a voltage circuit (L), having a current path (5) and having an arrangement for the optional connection of the voltage circuit (L) to the current path (5) or to a calibration system, characterised in that the arrangement comprises an opening (2), present in the housing of the meter for holding a contact device (3) connected to the calibration system, and a pivoting lever (H) which, on insertion of the contact device (3) into the said opening (2), is moved from an operating position, connecting the voltage circuit (L) to the current path (5), into a calibration position connecting the voltage circuit (L) to the calibration system, and which, on withdrawal of the contact device (3), is moved from the calibration position into the operating position.

2. Electricity meter according to Claim 1, characterised in that a fixed electrical connection, preferably formed by a flexible wire (12), exists between the pivoting lever (H) and the voltage circuit (L).

3. Electricity meter according to Claim 2, characterised in that the pivoting lever (H) is designed with two arms, and in that the one lever arm (9) is provided for producing the connection between the voltage circuit (L) and the current path (5), and the other is provided for producing the said connection between the voltage circuit (L) and the calibration system.

4. Electricity meter according to Claim 3, characterised in that the current path has a busbar (5) with a contact cam (11) projecting therefrom, and in that the one arm (9) of the pivoting lever (H) is designed as a contact part which, in the operating position, is electrically connected to this contact cam.

5. Electricity meter according to Claim 4, characterised by a spring (10) pressing the one lever arm (9), forming the contact part, against the contact cam (11).

6. Electricity meter according to Claim 1, characterised in that the contact device is formed by a plug-like pin or bolt (3) and the opening (2) is designed like a socket, and in that the pivoting lever (H) projects in a sprung manner into the path of the bolt when the latter is inserted into the socket.

7. Electricity meter according to Claims 3 and 6, characterised in that the other arm of the pivoting lever (H) has an operating surface (15) which runs obliquely with respect to the longitudinal axis of the socket (2), and hence of the bolt (3), and which crosses them when the pivoting lever (4) is in the operating position.

## Revendications

1. Compteur d'électricité comprenant une cellule de mesure (M), un circuit de tension (L), une voie de courant (5) et un agencement pour la connexion au choix du circuit de tension (L) à la voie de courant (5) ou au système d'étalonnage, caractérisé en ce que l'agencement comprend une ouverture (2) prévue dans le boîtier du compteur pour la reception d'un organe de contact (3) relié au système d'étalonnage et un levier pivotant (H) qui, lors de l'introduction de l'organe de contact (3) dans ladite ouverture (2), est déplacé d'une position de fonctionnement reliant le circuit de tension (L) à la voie de courant (5) dans une position d'étalonnage reliant le circuit de tension (L) au système d'étalonnage et qui, lors du retrait de l'organe de contact (3), est déplacé de la position d'étalonnage dans la position de fonctionnement.

2. Compteur d'électricité selon la revendication 1, caractérisé en ce qu'entre le levier pivotant (H) et le circuit de tension (L) est établie une liaison électrique fixe, de preference formée par un cordon ou un fil flexible (12).

3. Compteur d'électricité selon la revendication 2, caractérisé en ce que le levier pivotant (H) est réalisé de façon à presenter deux bras, que l'un des bras de levier (9) est prévu pour l'établissement de la liaison entre le circuit de tension (L) et la voie de courant (5) et l'autre pour l'établissement de la liaison entre le circuit de tension (L) et le système d'étalonnage.

4. Compteur d'électricité selon la revendication 3, caractérisé en ce que la voie de courant comprend un rail de courant (5) avec une came de contact (11) faisant saillie de celui-ci, et en ce que le bras (9) du levier pivotant (H) est réalisé sous forme d'une partie de contact reliée électriquement à la came de contact dans la position de fonctionnement.

5. Compteur d'électricité selon la revendication 4, caractérisé par un ressort (10) appliquant le bras de levier (9) formant la partie de contact contre la came de contact (11).

6. Compteur d'électricité selon la revendication 1, caractérisé en ce que l'organe de contact est formé par une goupille ou un boulon (3) en forme d'une fiche et que l'ouverture (2) est réalisée sous forme d'une douille, et que le levier pivotant (H) fait saillie, de façon élastique, dans la trajectoire du boulon lors de son introduction dans la douille.

7. Compteur d'électricité selon les revendications 3 et 6, caractérisé en ce que l'autre bras du levier pivotant (H) comprend une face d'actionnement (15) s'étendant obliquement par rapport à l'axe longitudinal de la douille (2) et ainsi du boulon (3) et croisant celle-ci dans la position de fonctionnement du levier pivotant (4).
